# EUROPEAN PATENT APPLICATION

(11) **EP 1 788 852 A2**
(43) Date of publication of application: **23.05.2007**
(21) Application number: 06253280.9
(22) Date of filing: 23.06.2006
(51) Int. Cl.: H05K 3/28, H01L 23/31

(54) **Method for packaging flash memory cards**

(30) Priority: 19.11.2005 US 284243
(71) Applicant: Liu, Chin-Tong, Noupu South Road Hsinchu (TW)
(72) Inventor: Liu, Chin-Tong, Noupu South Road Hsinchu (TW)
(74) Representative: Gee, Steven William

(57) **Abstract**

A method for packaging flash memory cards is provided, including a step of forming a protective membrane. The purpose of the protective membrane is to protect the circuit from the movement and the heat of the subsequent insert molding process. An insert molding step is used to seal the substrate in a monolithic structure. As the protective membrane is similar to the membrane found in eggshells and is followed by an insert molding step, the packaging method of the present invention is called eggshell insert molding (ESIM). The present invention can be applied to the improvement of the conventional COB and SMT packaging methods.

## Description

### FIELD OF THE INVENTION

The present invention generally relates to a packaging method for flash memory cards, and more specifically to a packaging method for flash memory cards using insert molding.

### BACKGROUND OF THE INVENTION

As the digital products, such as digital camera, mobile phones, PDA, are becoming popular, the consumer demands on the flash memory cards increase. The current types of the flash memory cards include compact flash (CF), card, smart media card (SMC), multimedia card (MMC), secure digital (SD) card, and memory stick (MS) card. The large amount of the flash memory card sales indicates a large market of flash memory card packaging for the packaging industry. In other words, an improved and cost-effective packaging method for the flash memory cards is proved to an important factor for the competition for the manufacturers.

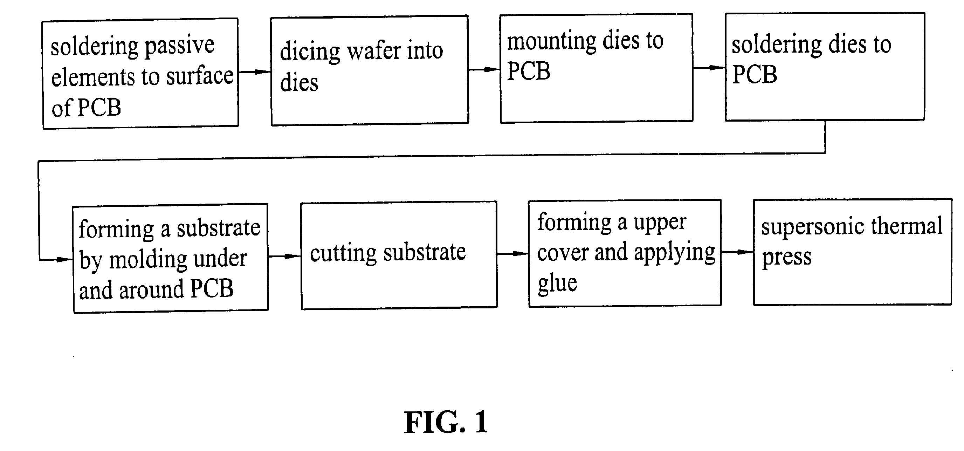

FIG. 1 shows a conventional chip-on board (COB) packaging method. As shown in FIG. 1, the passive elements are first soldered to the printed circuit board (PCB). Then, the wafer is diced, mounted and soldered to the PCB. A substrate of the PCB is formed and cut. Finally, a housing shell is manufactured with a glue applied, followed by a step of using supersonic thermal pressing to glue the housing shell to the substrate.

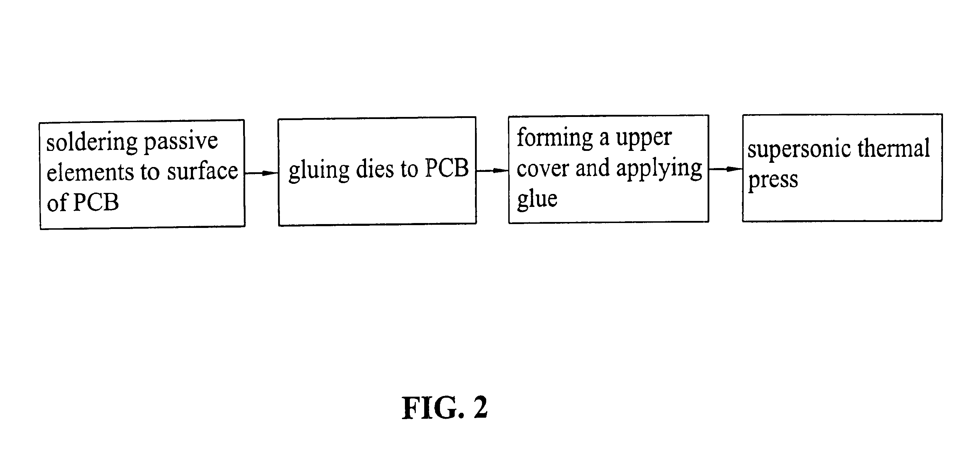

Surface mount technology (SMT) is a method for constructing electronic circuits in which the components are mounted directly onto the surface of PCB. In the industry the SMT has largely replaced the previous packaging method of fitting components with wire leads into holes in the circuit board. FIG. 2 shows a conventional SMT method, including the steps of: (a) soldering passive elements to the PCB, (b) die being mounted to the surface of PCB, (c) forming a housing shell with a back glue, and (d) applying supersonic thermal pressing for gluing the shell to the PCB.

Both COB and SMT have the drawbacks of only the circumference of the substrates or the PCB being bonded to the housing shell. With this type of bonding structure, the shell is easily disintegrated from the substrate/PCB after repetitive uses, and it is easy for water/humidity to leak in to cause damage to the circuit.

In another related application, a packaging method is proposed to improve the above drawbacks. For both COB and SMT, the final steps of forming a housing shell and applying the housing shell using supersonic thermal pressing are replaced by a step of insert molding so that the flash memory card is sealed within a monolithic structure to avoid the above drawbacks of the conventional packaging methods.

### SUMMARY OF THE INVENTION

The present invention has been made to overcome the aforementioned drawback of conventional packaging methods. The primary object of the present invention is to provide a packaging structure with a protective membrane layer, and a method of forming the same. With a protective membrane layer to protect the circuitry, an insert molding process can be applied to the flash memory cards to form a sealed package.

To achieve the above object, the present invention includes a method including a step of forming a protective membrane to protect the circuitry from the subsequent insert molding step. The present invention can be applied to the improvement of the conventional COB and SMT packaging methods.

In comparison with the conventional packaging methods, the present invention provides a flash memory cards packaging method that provides better protection against water leakage and stress on the structure caused by repetitive uses. Furthermore, the packaging methods are simplified so that the manufacture cost can be reduced for the flash memory cards.

The foregoing and other objects, features, aspects and advantages of the present invention will become better understood from a careful reading of a detailed description provided herein below with appropriate reference to the accompanying drawings.

### BRIEF DESCRIPTION OF THE DRAWINGS

The present invention can be understood in more detail by reading the subsequent detailed description in conjunction with the examples and references made to the accompanying drawings, wherein:
FIG. 1 shows a flowchart of a conventional chip-on-board packaging method;
FIG. 2 shows a flowchart of a conventional SMT packaging method;
FIG. 3 shows a flowchart of the first embodiment of the present invention with a chip-on-board packaging method; and
FIG. 4 shows a flowchart of the second embodiment of the present invention with a SMT packaging method.

### DETAILED DESCRIPTION OF THE PREFERRED EMBODIMENTS

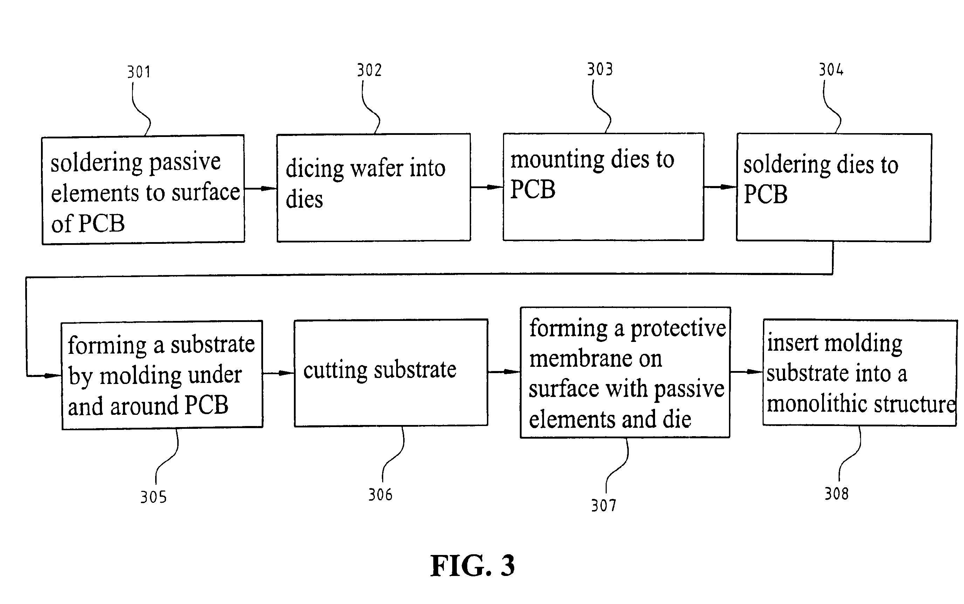

FIG. 3 shows a flowchart of the first embodiment of the present invention. The first embodiment of the present invention is an improvement over the conventional COB packaging method. As shown in FIG. 3, the present invention includes the following steps. In step 301, the passive elements are soldered to the surface of the PCB. Step 302 is to dice the wafer into dies. Step 303 is to mount the dies to the PCB, and step 304 is to solder the dies to the PCB. In step 304, a substrate is formed by molding under and around the PCB to form the bottom half of the housing shell for the PCB. Step 305 is to cut the substrate. Up to this point, the steps of present invention are identical to the conventional COB packaging method.

Step 306 is to form a protective membrane on surface of the substrate with circuit, including passive elements and die. The purpose of the protective membrane is to protect the circuit from the movement and the heat of the subsequent insert molding process. The protective membrane can be made of any adhesive materials, such as resin or glue. The techniques to form the membrane is not limited to any specific type, any conventional techniques forming a thin layer, such as, spread, printing and so on can be used. Step 307 is to use an insert molding step to seal the substrate in a monolithic structure. As the protective membrane is similar to the membrane found in eggshells and is followed by an insert molding step, the packaging method of the present invention is called eggshell insert molding (ESIM).

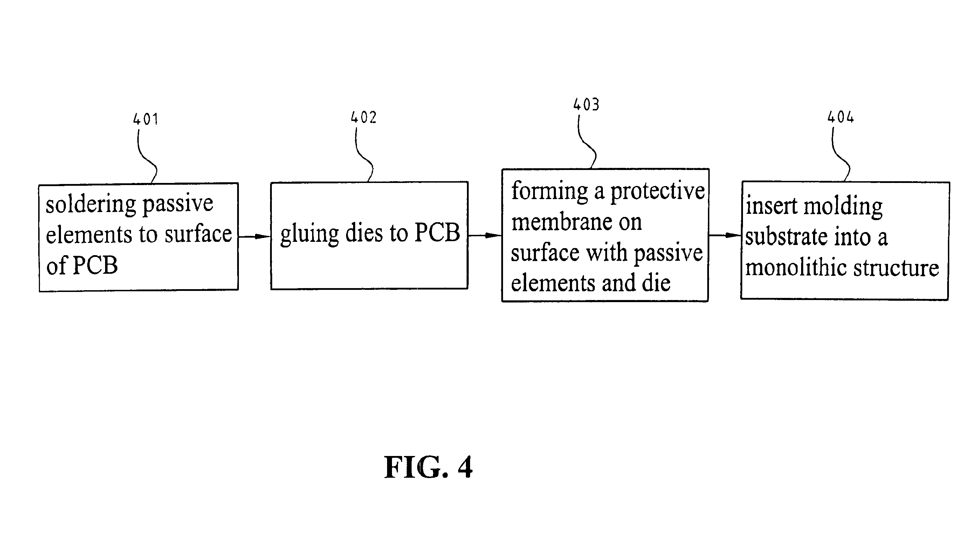

FIG. 4 shows a flowchart of the second embodiment of the present invention. The second embodiment of the present invention is an improvement over the conventional SMT packaging method. As shown in FIG. 4, the present invention includes the following steps. In step 401, the passive elements are soldered to the PCB. In step 402, the die is glued to the surface of the PCB. Up to this point, the steps of the present invention are identical to the steps of the conventional SMT packaging methods.

Step 306 is to form a protective membrane on surface of the substrate with circuit, and step 307 is to use an insert molding step to seal the substrate in a monolithic structure.

As the above embodiments show, the present invention of packaging method using insert molding with a protective membrane layer can be used with conventional COB and SMT packaging methods.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A method for packaging flash memory cards, comprising the steps of:
soldering passive elements to surface of an PCB;
dicing an wafer into dies;
mounting said dies to said PCB;
soldering said dies to said PCB;
forming a substrate by molding under and around said PCB;
cutting said substrate;
forming a protective membrane on said surface with said passive elements and said die; and
insert molding said substrate into a monolithic structure.

2. The method as claimed in claim 1, wherein said protective membrane is made of glue.

3. The method as claimed in claim 1, wherein said protective membrane is made of resin.

4. A method for packaging flash memory cards, comprising the steps of:
soldering passive elements to surface of an PCB;
gluing dies to said PCB;
forming a protective membrane on said surface with said passive elements and said die; and
insert molding said substrate into a monolithic structure.

5. The method as claimed in claim 5, wherein said membrane is made of glue.

6. The method as claimed in claim 5, wherein said membrane is made of resin.
